# EUROPÄISCHE PATENTSCHRIFT

(11) **EP 1 194 948 B1**
(45) Veröffentlichungstag und Bekanntmachung des Hinweises auf die Patenterteilung: **10.01.2007**
(21) Anmeldenummer: 00954315.8
(22) Anmeldetag: 12.07.2000
(51) Int. Cl.: H01L 21/00

(54) **HANDHABUNGSSYSTEM**
HANDLING SYSTEM
SYSTEME DE MANIPULATION

(30) Priorität: 12.07.1999 DE 19932063
(43) Veröffentlichungstag der Anmeldung: 10.04.2002
(73) Patentinhaber: centrotherm thermal solutions GmbH + Co. KG, 89143 Blaubeuren (DE)
(72) Erfinder: HARTUNG, Rolf, D-89143 Blaubeuren (DE)
(74) Vertreter: Lippert, Stachow & Partner
(86) Internationale Anmeldenummer: PCT/DE2000/002257
(87) Internationale Veröffentlichungsnummer: WO 2001/004932

(56) Entgegenhaltungen:
- US-A- 4 816 116
- US-A- 5 919 529
- PATENT ABSTRACTS OF JAPAN vol. 1998, no. 08, 30. Juni 1998 (1998-06-30) -& JP 10 084029 A (TOKYO ELECTRON LTD), 31. März 1998 (1998-03-31) -& US 5 972 110 A (AKIMOTO) 26. Oktober 1999 (1999-10-26)
- PATENT ABSTRACTS OF JAPAN vol. 1995, no. 01, 28. Februar 1995 (1995-02-28) -& JP 06 283457 A (NEC KANSAI LTD), 7. Oktober 1994 (1994-10-07)

## Beschreibung

Die Erfindung betrifft ein Handhabungssystem zur Übernahme von aus einer Kassette bereitgestellten Wafern und zur Übergabe derselben an eine Vakuumkammer zur thermischen Behandlung der Wafer, mit einer externen und einer internen Handhabungsvorrichtung, wobei die interne Handhabungsvorrichtung wenigstens eine in mehreren Freiheitsgraden verfahrbare Gabel aufweist, die mit Greifern der externen Handhabungsvorrichtung in Wirkungsverbindung steht. Unter den eingangs genannten Wafern können Halbleiterscheiben verstanden werden, die in einer Bearbeitungsstation, z.B. in einer Vakuumkammer, einer thermischen Behandlung unterzogen werden sollen, beispielsweise um einen Vacuum Soldering Prozess bzw. Wafer Bumping Prozess in einer Wafer Bumping Vorrichtung (Wafer Bumping Equipment), welche die Vakuumkammer umfasst, durchzuführen. Dazu ist es erforderlich, die Wafer mittels einer geeigneten Handhabungsvorrichtung aus einem Transportbehälter (FOUP = Front Open Unified Pot) zu entnehmen und in die Vakuumkammer zu transportieren. Das bedeutet jedoch, dass die Vakuumkammer geöffnet werden muss, d.h. zunächst muss in der Vakuumkammer Normaldruck hergestellt werden, gleichzeitig entsteht ein Wärmeverlust und eine Veränderung der Atmosphäre in der Vakuumkammer. Folglich muss die Vakuumkammer nach der Bestückung mit einem oder mehreren Wafern gespült werden und die gewünschte Gaszusammensetzung, z.B. durch Einleiten eines Inertgases, oder eines Prozessgases,' hergestellt werden und gleichzeitig das für den jeweiligen Bearbeitungsprozess erforderliche Vakuum wieder aufgebaut werden. Außerdem müssen die Wafer auf die notwendige Prozesstemperatur aufgeheizt werden.

Nach der Beendigung des Bearbeitungsprozesses in der Vakuum-kammer ist es erforderlich, die Wafer vor deren Entnahme gleichmäßig auf eine Temperatur im Bereich der Raumtemperatur abzukühlen, um bei der Entnahme aus der Vakuumkammer einen Temperaturschock durch eine eventuell extreme Abkühlgeschwindigkeit (großer Temperaturgradient) zu vermeiden.

Es ist folglich wünschenswert, dass das Handling der Wafer, insbesondere der Transport der Wafer in die Vakuumkammer und das Entnehmen der Wafer aus der Vakuumkammer, durch ein geeignetes Handhabungssystem möglichst einfach und schnell erfolgen kann.

So geht aus der US-A-5 919 529 eine Vorrichtung und ein Verfahren zur Behandlung von Substraten hervor, die mehrere Transporteinrichtungen umfasst. Diese Transporteinrichtungen sind derart angeordnet, dass sich deren Arbeitsbereiche teilweise überschneiden, so dass die Substrate nacheinander durch eine Vielzahl von Bearbeitungsstationen transportiert werden können.

Weiterhin wird in der US-A-4 816 116 ein Wafer Transfersystem beschrieben, mit dem Wafer von außen in eine Vakuumkammer transportiert werden können. Hierzu befindet sich innerhalb der Kammer ein drehbarer Transferarm, dessen Waferaufnahme nach außen geführt werden kann. Dieses Transfersystem ist mechanisch sehr aufwändig und enthält mehrere verschleißbehaftete Gelenke.

Schließlich wird in der US-A-5 972 110 ein Transfersystem beschrieben, mit dem Wafer in Behandlungseinheiten transportiert werden können, wobei auch eine Variante beschrieben wird, bei der die Wafer von einer Seite in die Behandlungskammer hinein transportiert werden und auf der gegenüberliegenden Seite entnommen werden können.

Der Erfindung liegt nunmehr die Aufgabe zugrunde, ein Handhabungssystem zu schaffen, mit dem eine sichere und schnelle Handhabung der Wafer bei Vermeidung der Nachteile des Standes der Technik ermöglicht wird und das insbesondere eine lange Nutzungsdauer bei geringer mechanischer und thermischer Beanspruchung aufweist.

Diese der Erfindung gemäß dem Anspruch 1 zugrundeliegende Aufgabenstellung wird bei einem Handhabungssystem der eingangs genannten Art dadurch gelöst, dass die durch die externe Handhabungsvorrichtung in die Vakuumkammer transportierten Wafer auf einer Kühlplatte einer Halteeinrichtung, bestehend aus der Kühlplatte und einer Heizplatte absetzbar sind, wobei die Gabel der internen Handhabungsvorrichtung zwischen der Heizplatte und der Kühlplatte an einer Querführung verfahrbar ist und dass die interne Handhabungsvorrichtung in einem gekühlten Bereich der Vakuumkammer untergebracht ist.

Damit wird eine einfache Trennung in ein internes und ein externes Handhabungssystem erreicht, so dass der Bearbeitungsprozess innerhalb der Vakuumkammer vollkommen abgeschlossen werden kann und die Vakuumkammer nur kurzzeitig zur Entnahme und Neubestückung geöffnet werden muss.

Außerdem kann damit der Wafer innerhalb der Vakuumkammer auf die für den jeweiligen Bearbeitungsprozess erforderliche Bearbeitungstemperatur aufgeheizt und nach Abschluss des Bearbeitungsprozesses durch Umsetzen auf die Kühlplatte auf eine für die Entnahme aus der Vakuumkammer geeignete Temperatur abgekühlt werden. Damit kann die Offenzeit der Vakuumkammer weiter verkürzt werden.

In einer Fortführung der Erfindung ist die Gabel des internen Handhabungssystemes unter die Ablageposition des Wafers auf der Halteeinrichtung verfahrbar. Damit wird eine einfache Handhabung der Wafer erreicht, da diese durch die Gabel ohne weitere mechanische Hilfsmittel lediglich zu untergreifen und zur nächsten Ablageposition zu transportieren sind.

Die Kühlplatte und die Heizplatte können nebeneinander, oder auch hintereinander angeordnet werden.

Bevorzugt ist der internen Handhabungsvorrichtung eine Kühleinrichtung zur Temperierung zugeordnet.

In einer weiteren besondere Fortführung der Erfindung kann die Mehrfachanordnung aus 12 oder 24 Ebenen übereinander bestehen, die nacheinander oder simultan (d.h. auf einmal) bestückbar sind.

In einer vorteilhaften Variante der Erfindung ist die Gabel des internen Handhabungssystemes vorheizbar, so dass das von der Heizplatte zu entnehmende Wafer ohne vorherige Abkühlung entnommen werden kann.

Die Aufheizung der Gabel kann vorteilhaft dadurch erfolgen, dass diese vor der Übernahme eines Wafers so lange mit der Heizplatte in Kontakt steht, bis eine vorgegebene Temperatur erreicht ist.

In einer weiteren vorteilhaften Fortführung der Erfindung ist gegenüber der internen Handhabungsvorrichtung eine weitere Handhabungsvorrichtung installiert.

Es können auch mehrere Vakuumkammern übereinander und/oder nebeneinander gestapelt werden.

Um einen kontinuierlichen Prozessdurchlauf zu ermöglichen, kann eine weitere Entnahmemöglichkeit für die Wafer über eine Rückwand der Kammer vorgesehen werden, indem die Rückwand der Vakuumkammer mit einer verschließbaren Öffnung versehen wird, der ein zweites Handhabungssystem oder ein anderes Transportsystem zugeordnet ist.

Um das Eindringen von Staub in die Vakuumkammer zu verhindern, ist diese und der Übergabebereich von der Kassette mit einer Abdeckung zur Realisierung eines staubfreien Bereiches umgeben. Dieser Bereich innerhalb der Abdeckung kann vorteilhaft mit Wasserstoff/Stickstoff unter geringen Überdruck geflutet werden.

Die Erfindung soll nachfolgend an einem Ausführungsbeispiel näher erläutert werden. In den zugehörigen Zeichnungsfiguren zeigen:

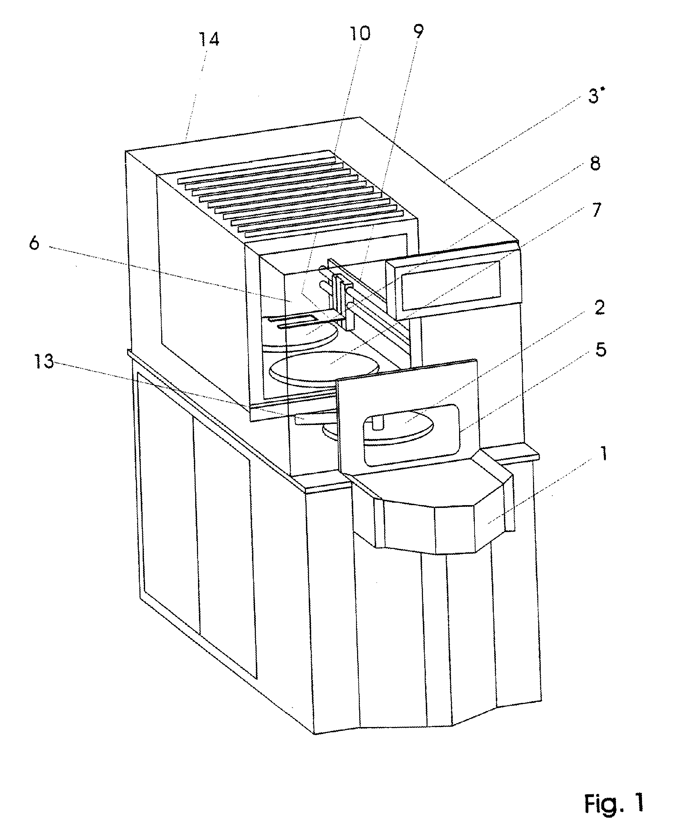

- Fig. 1: eine schematische Darstellung einer erfindungsgemäßen Vakuumkammer mit einem internen Handhabungssystem; und
- Fig. 2: den schematischen Aufbau des internen Handhabungssystems.

Die zu behandelnde Ware, im vorliegenden Fall beispielsweise ein 300 mm Wafer, wird in einer Spezialkassette (FOUP) auf eine übliche Ladestation 1 gestellt. Eine externe Handhabungsvorrichtung 2, die sich unter einer Abdeckung 3 befindet, entnimmt den Wafer 4 durch den Port 5 aus der Spezialkassette und transportiert diesen bei geöffneter Vakuumkammer 6 auf eine in dieser befindliche Kühlplatte 7 einer Halteeinrichtung, die aus der Kühlplatte 7 und einer Heizplatte 8 besteht. Von dieser Kühlplatte 7 aus übernehmen nicht dargestellte Greifer der Halteeinrichtung den Wafer 4 und halten ihn auf einer vorgegebenen Höhe fest, solange bis die externe Handhabungsvorrichtung 2 zurückgefahren und die Vakuumkammer 6 geschlossen ist.

Jetzt beginnt der Bearbeitungsprozess in der Vakuumkammer 6 , oder einem Vakuumofen, indem eine interne Handhabungsvorrichtung 9 mittels einer Gabel 10 den Wafer 4 von dem Greifer der Halteeinrichtung übernimmt. Mit der Gabel 10 wird der Wafer 4 über die Heizplatte 8 transportiert und auf einer weiteren, dieser Heizplatte 8 zugeordneten Halteeinrichtung abgesenkt. Dabei wird die Gabel 10 ein wenig abgesenkt und zurück in eine günstige Warteposition gefahren.

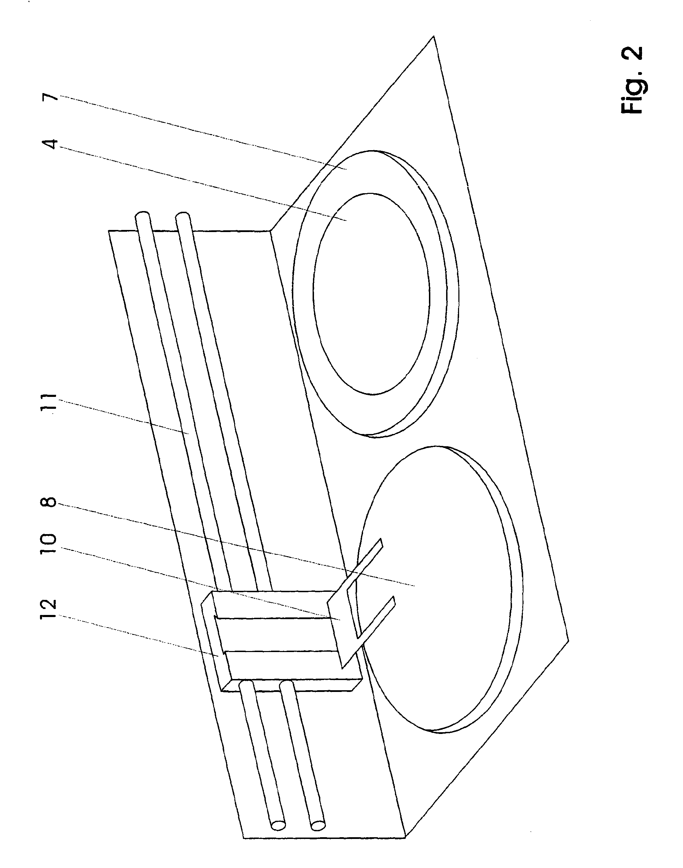

Die Kühlplatte 7 und die Heizplatte 8 sind nebeneinander in der Vakuumkammer 6 angeordnet, wie schematisch aus Fig. 2 ersichtlich ist. Hinter den Platten 7, 8 befindet sich das interne Handhabungssystem 9 mit einer Querführung 11, an der die Gabel 10 in einer Aufnahme 12 seitlich und vertikal verfahrbar geführt ist.

Am Ende der über der Heizplatte 7 durchgeführten thermischen Behandlung wird der Wafer 4 mit der Haltevorrichtung angehoben. Jetzt fährt die Gabel 10 wieder unter den Wafer 4 und übernimmt diesen. Die interne Handhabungsvorrichtung 9 transportiert den Wafer 4 über die Kühlplatte 7 und senkt ihn ab bis zur Berührung mit der Kühlplatte 7. Nach Erreichen einer vorgegebenen Temperatur wird die Vakuumkammer 6 geöffnet. Der Greifer 13 (schematisch dargestellt) der externen Handhabungsvorrichtung 2 entnimmt den Wafer 4 und transportiert ihn wieder zurück in die Transportkassette (FOUP).

Anschließend kann der Prozess mit einem neuen Wafer 4 wiederholt werden.

Für die Funktion der internen Handhabungsvorrichtung 9 ist wichtig, dass diese in einem gekühlten Bereich der Vakuumkammer 6 untergebracht ist. Der internen Handhabungsvorrichtung 9 kann eine Kühleinrichtung zur Temperierung zugeordnet werden.

Anstelle der Verwendung von zwei nebeneinander befindlichen Platten 7, 8 ist es auch möglich, eine Mehrfachanordnung vorzusehen, indem Kühl- und Heizplatten 7, 8 mehrfach übereinander in mehreren Ebenen angebracht werden. So ist es möglich, 12 oder 24 Ebenen übereinander vorzusehen.

Es ist möglich, die Ebenen nacheinander zu bestücken, oder simultan (d.h. auf einmal), was zu einer erheblichen Verkürzung der Zykluszeit führt.

In einer Variante können die Platten 7, 8 anstelle nebeneinander (Bild 2) auch hintereinander angeordnet werden, so daß sich die Kühlplatten 7 vor den Heizplatten 8 befinden. Das hätte den Vorteil einer in die Tiefe der Vakuumkammer 6 gesehenen Temperaturstaffelung. D.h. der kühlere Bereich ist vorn, also im Übergabebereich der externen Handhabungsvorrichtung 2 zur internen Handhabungsvorrichtung 5.

Um einen Wärmeschock bei der Übernahme eines aufgeheizten Wafers nach der Behandlung in der Vakuumkammer 6 zu vermeiden, wird die Gabel 10 vorgeheizt. Das Vorheizen kann dadurch erfolgen, dass die Gabel 10 vor der Übernahme eines Wafers so lange mit der Heizplatte 8 in Kontakt gebracht wird, bis eine gewünschte Temperatur erreicht ist.

Weiterhin ist es möglich, gegenüberliegend zur internen Handhabungsvorrichtung 9 eine weitere Handhabungsvorrichtung zu installieren, oder auch mehrere Vakuumkammern 6 übereinander und/oder nebeneinander zu stapeln.

In einer besonderen Variante der Erfindung ist eine Entnahmemöglichkeit für die Ware (Wafer 4) über die Rückwand 14 der Vakuumkammer 6 vorgesehen. Die Entnahme kann über ein zweites externe Handhabungsgerät oder ein anderes Transportsystem erfolgen. Auf diese Weise lässt sich ein Durchlaufprinzip realisieren, indem die Wafer vom der ersten externen Handhabungsvorrichtung 1 in die Vakuumkammer 2 übergeben und nach der vorgesehenen Behandlung vom der zweiten externen Handhabungsvorrichtung entnommen werden. Für die externen Handhabungsvorrichtungen sind handelsübliche Vorrichtungen einsetzbar.

Innerhalb der Vakuumkammer 6 werden die Wafer 4 automatisch von einer Wärmequelle (Heizplatte 8) zu einer Kühlplatte 7 transportiert. Das Wafertransportsystem umfasst drei Abschnitte.

Der erste Abschnitt betrifft den Transport innerhalb der Vakuumkammer 6. Es umfasst die Übernahme der Wafer 4 am Kammereingang, die Behandlung der Wafer 4 innerhalb der Vakuumkammer 6 und die Zurückbeförderung der Wafer 4 zum Kammereingang.

Der zweite Abschnitt befindet sich vor der Vakuumkammer 6 und zwischen dem Eingang der Vakuumkammer 6 und dem Ausgang des "semi standard load port" für 300 mm Wafer.

Die externe Handhabungsvorrichtung 2 (Handling System) übernimmt die Wafer 4 von diesem Port 5 und transportiert diese in die Vakuumkammer 6.

Am Ende beispielsweise des "Wafer Bump Reflow Soldering"-Prozesses in der Vakuumkammer 6 übernimmt die externe Handhabungsvorrichtung 2 die Wafer 4 und transportiert diese über den "standard load port" in die FOUP-Box zurück.

Der dritte Abschnitt befindet sich vor dem "standard load port", wobei hier die Transportkassette (FOUP = Front Open Unified Pod) mit den darin befindlichen Wafern 4 manuell oder mittels eines Roboters entnommen werden kann.

Der gesamte Bereich, in dem die Wafer 4 bewegt werden, ist gegen Umwelteinflüsse geschützt, so dass keinerlei Partikel in diesen Bereich eindringen können. Dieser Bereich kann mit Wasserstoff/Stickstoff unter geringen Überdruck geflutet werden.

### Bezugszeichenliste

- 1: Ladestation
- 2: externe Handhabungsvorrichtung
- 3: Abdeckung
- 4: Wafer
- 5: Port
- 6: Vakuumkammer
- 7: Kühlplatte
- 8: Heizplatte
- 9: interne Handhabungsvorrichtung
- 10: Gabel
- 11: Querführung
- 12: Aufnahme
- 13: Greifer
- 14: Rückwand

## Patentansprüche

1. Handhabungssystem zur Übernahme von aus einer Kassette bereitgestellten Wafern (4) und zur Übergabe derselben an eine Vakuumkammer (6) zur thermischen Behandlung der Wafer (4), mit einer externen und einer internen Handhabungsvorrichtung (2, 9), wobei die interne Handhabungsvorrichtung (9) wenigstens eine in mehreren Freiheitsgraden verfahrbare Gabel (10) aufweist, die mit Greifern (13) der externen Handhabungsvorrichtung (2) in Wirkungsverbindung steht, dass die interne Handhabungsvorrichtung (9) aus einer Querführung (11) besteht, an der die Gabel (10) in einer Aufnahme (12) seitlich und vertikal verfahrbar geführt ist **dadurch gekennzeichnet, dass** die durch die externe Handhabungsvorrichtung (2) in die Vakuumkammer (6) transportierten Wafer (4) auf einer Kühlplatte (7) und auf einer Heizplatte (8) absetzbar sind und dass die interne Handhabungsvorrichtung (9) in einem gekühlten Bereich der Vakuumkammer (6) untergebracht ist.

2. Handhabungssystem nach Anspruch 1, **dadurch gekennzeichnet, dass** die Gabel (10) unter die Ablageposition des Wafers (4) auf der Halteeinrichtung verfahrbar ist.

3. Handhabungssystem nach Anspruch 1, **dadurch gekennzeichnet, dass** die Kühlplatte (7) und die Heizplatte (8) nebeneinander angeordnet sind.

4. Handhabungssystem nach Anspruch 1, **dadurch gekennzeichnet, dass** die Kühlplatte (7) und die Heizplatte (8) hintereinander angeordnet sind.

5. Handhabungssystem nach Anspruch 1 , **dadurch gekennzeichnet, dass** der internen Handhabungsvorrichtung (9) eine Kühleinrichtung zur Temperierung zugeordnet ist.

6. Handhabungssystem nach einem der Ansprüche 1 bis 5, **dadurch gekennzeichnet**, da anstelle der Verwendung von zwei nebeneinander befindlichen Platten (7), eine Mehrfachanordnung vorgesehen ist, indem Kühl- und Heizplatten (7, 8) mehrfach übereinander angebracht werden.

7. Handhabungssystem nach Anspruch 1, **dadurch gekennzeichnet, dass** die Mehrfachanordnung aus 12 oder 24 Ebenen übereinander besteht.

8. Handhabungssystem nach Anspruch 7 , **dadurch gekennzeichnet, dass** die Ebenen nacheinander oder simultan (d.h. auf einmal) bestückbar sind.

9. Handhabungssystem nach Anspruch 1 und 2, **dadurch gekennzeichnet, dass** die Gabel (10) vorheizbar ist.

10. Handhabungssystem nach Anspruch 9, **dadurch gekennzeichnet, dass** die Gabel (10) vor der Übernahme eines Wafers (4) so lange mit der Heizplatte (7) in Kontakt steht, bis eine vorgegebene Temperatur erreicht ist.

11. Handhabungssystem nach einem der Ansprüche 1 bis 10, **dadurch gekennzeichnet, dass** gegenüber der internen Handhabungsvorrichtung (9) eine weitere Handhabungsvorrichtung installiert ist.

12. Handhabungssystem nach einem der Ansprüche 1 bis 11, **dadurch gekennzeichnet, dass** mehrere Vakuumkammern (6) übereinander und/oder nebeneinander gestapelt sind.

13. Handhabungssystem nach einem der Ansprüche 1 bis 12, **dadurch gekennzeichnet, dass** eine Entnahmemöglichkeit für die Ware (Wafer) über die Rückwand (14) der Vakuumkammer (6) vorgesehen ist.

14. Handhabungssystem nach Anspruch 13, **dadurch gekennzeichnet, dass** die Rückwand (14) der Vakuumkammer (6) mit einer verschließbaren Öffnung versehen ist, der eine zweites externe Handhabungsvorrichtung oder ein anderes Transportsystem zugeordnet ist.

15. Handhabungssystem nach einem der Ansprüche 1 bis 14, **dadurch gekennzeichnet, dass** die Vakuumkammer (6) und der Übergabebereich von der Kassette mit einer gemeinsamen Abdeckung (3) zur Realisierung eines staubfreien Bereiches umgeben ist.

16. Handhabungssystem nach Anspruch 15, **dadurch gekennzeichnet, dass** der Bereich innerhalb der Abdeckung (3) mit Wasserstoff/Stickstoff unter geringen Überdruck geflutet ist.

## Claims

1. Handling system to take wafers (4) provided from a cassette and to transfer these to a vacuum chamber (6) for thermal treatment of the wafers (4) with one external and one internal handling facility (2, 9), whereby the internal handling facility (9) has at least one fork (10) capable of travelling in several degrees of freedom, which operate in connection with grabs (13) on the external handling facility (2) - **characterised in that** the wafers (4) transported into the vacuum chamber (6) by the external handling facility (2) can be placed on both a cold plate (7) or a heated plate (8) and that the internal handling facility (9) consists of a cross guide (11) to which the fork (10) in a receptacle (12) can travel in both a sideways and vertical direction, and that the internal handling facility (9) is located in a cooled area of the vacuum chamber (6).

2. Handling system in line with claim 1, **characterised in that** the fork (10) below the delivery position of the wafer (4) can travel on the holding device.

3. Handling system in line with claim 1, **characterised in that** the cold plate (7) and the heated plate (8) are arranged next to one another.

4. Handling system in line with claim 1, **characterised in that** the cold plate (7) and the heated plate (8) are arranged behind one another.

5. Handling system in line with claim 1, **characterised in that** the internal handling facility (9) is assigned a cooling facility for temperature equalisation.

6. Handling system in line with one of claims 1 - 5, **characterised in that** instead of using two plates (7) located next to one another, a multiple arrangement is provided whereby cold and heated plates (7, 8) are fixed repeatedly above one another.

7. Handling system in line with claim 1, **characterised in that** the multiple arrangement consists of 12 or 24 levels above one another.

8. Handling system in line with claim 7, **characterised in that** the levels are assembled one after the other or simultaneously (i.e. all at once).

9. Handling system in line with claims 1 and 2, **characterised in that** the fork (10) can be preheated.

10. Handling system in line with claim 9, **characterised in that** the fork (10), prior to taking a wafer (4), is in contact with the heated plate (7) until a specified temperature is reached.

11. Handling system in line with one of the claims 1 - 10, **characterised in that** a further handling facility is installed opposite the internal handling system (9).

12. Handling system in line with one of the claims 1 - 11, **characterised in that** several vacuum chambers (6) are stacked above one another and/or next to one another,

13. Handling system in line with one of the claims 1 - 12, **characterised in that** the option is provided to remove the goods (wafers) via the rear panel (14) of the vacuum chamber (6).

14. Handling system in line with claim 13, **characterised in that** the rear panel (14) of the vacuum chamber (6) is provided with a lockable opening to which is assigned a second external handling system or another transportation system.

15. Handling system in line with one of claims 1 - 14, **characterised in that** the vacuum chamber and the delivery area of the cassette is surrounded by a shared cover (13) to create a dust-free area.

16. Handling system in line with claim 15, **characterised in that** hydrogen/nitrogen streams over the area inside the cover (3) under slight excess pressure.

## Revendications

1. Système de manutention servant à prendre en charge des plaques (4) fournies depuis une cassette et à les transférer vers une chambre sous vide (6) en vue du traitement thermique de ces mêmes plaques (4), avec un dispositif de manutention externe et un dispositif de manutention interne (2, 9), le dispositif de manutention interne (9) présentant au moins une fourche (10) pouvant se déplacer selon plusieurs degrés de liberté et opérant en liaison avec des préhenseurs (13) sur le dispositif de manutention externe (2), **caractérisé en ce que** les plaques (4) transportées jusque dans la chambre sous vide (6) par le dispositif de manutention externe (2) peuvent être déposées sur une plaque de refroidissement (7) et une plaque chauffante (8) et que le dispositif interne de manutention (9) se compose d'un guide transversal (11) vers lequel la fourche (10) dans un réceptacle (12) peut se déplacer dans le sens latéral et vertical, et **en ce que** le dispositif de manutention interne (9) est situé dans un endroit refroidi de la chambre sous vide (6).

2. Système de manutention selon la revendication 1, **caractérisé en ce que** la fourche (10) située sous la position de déposition de la plaque (4) peut se déplacer sur l'équipement de retenue.

3. Système de manutention selon la revendication 1, **caractérisé en ce que** la plaque de refroidissement (7) et la plaque chauffante (8) sont agencées l'une à côté de l'autre.

4. Système de manutention selon la revendication 1, **caractérisé en ce que** la plaque de refroidissement (7) et la plaque chauffante (8) sont agencées l'une derrière l'autre.

5. Système de manutention selon la revendication 1, **caractérisé en ce qu'**au dispositif de manutention interne (9) est affecté un équipement de refroidissement destiné à égaliser la température.

6. Système de manutention selon les revendications 1 à 5, **caractérisé en ce qu'**au lieu d'utiliser deux plaques (7) situées l'une à côté de l'autre, un agencement multiple est prévu permettant de fixer répétitivement les plaque de refroidissement et les plaques chauffantes (7, 8) les unes au dessus des autres.

7. Système de manutention selon la revendication 1, **caractérisé en ce que** l'agencement se compose de 12 ou 24 niveaux les uns au dessus des autres.

8. Système de manutention selon la revendication 7, **caractérisé en ce que** les niveaux sont assemblés les uns après les autres ou simultanément (c'est-à-dire d'un seul coup).

9. Système de manutention selon les revendications 1 et 2, **caractérisé en ce qu'**il est possible de préchauffer la fourche (10).

10. Système de manutention selon la revendication 9, **caractérisé en ce que** la fourche (10), avant la prise en charge d'une plaque (4), est en contact avec la plaque chauffage (7) jusqu'à ce qu'une température prescrite soit atteinte.

11. Système de manutention selon l'une des revendications 1 à 10, **caractérisé en ce que** un dispositif de poursuite de la manutention est installé en face du dispositif de manutention interne (9).

12. Système de manutention selon l'une des revendications 1 à 11, **caractérisé en ce que** plusieurs chambres sous vide (6) sont empilées les unes sur les autres et/ou les unes à côté des autres.

13. Système de manutention selon l'une des revendications 1 à 12, **caractérisé en ce qu'**il est prévu une possibilité pour prélever les produits (les plaques) par le biais du panneau arrière (14) de la chambre sous vide (6).

14. Système de manutention selon la revendication 13, **caractérisé en ce que** la paroi arrière (14) de la chambre sous vide (6) est équipée d'une ouverture obturable à laquelle est affectée un second système de manutention externe ou un autre système de transport.

15. Système de manutention selon l'une des revendications 1 à 14, **caractérisé en ce que** la chambre sous vide et la zone de remise de la cassette est entourée d'un couvercle conjoint (13) destiné à créer une zone exempte de poussière.

16. Système de manutention selon la revendication 15, **caractérisé en ce que** la zone située à l'intérieur du couvercle (3) est traversée par un flux d'hydrogène / azote en légère surpression.
